# FASCICULE DE BREVET EUROPEEN

(11) **EP 0 776 076 B1**
(45) Date de publication et mention de la délivrance du brevet: **03.04.2002**
(21) Numéro de dépôt: 96402406.1
(22) Date de dépôt: 12.11.1996
(51) Int. Cl.: H01S 5/30, H01S 5/10, H01S 5/32, G02F 1/015, H01L 31/0352

(54) **Dispositif optoélectronique à puits quantiques**
Optoelektronische Quantumwell-Vorrichtung
Optoelectronic quantum well device

(30) Priorité: 21.11.1995 FR 9513785
(43) Date de publication de la demande: 28.05.1997
(73) Titulaire: Thales, 75008 Paris (FR)
(72) Inventeur: Duboz, Jean-Yves, 94117 Arcueil Cedex (FR)

(56) Documents cités:
- EP-A- 0 549 132
- DE-A- 4 135 813
- APPLIED PHYSICS LETTERS, vol. 66, no. 2, 9 Janvier 1995, pages 218-220, XP002008844 V.BERGER ET AL.: "Normal incidence intersubband absorption in vertical quantum wells"
- APPLIED PHYSICS LETTERS, vol. 53, no. 12, 19 Septembre 1988, pages 1027-1029, XP000039349 K.W.GOOSSEN ET AL.: "Grating enhancement of quantum well detector response"
- APPLIED PHYSICS LETTERS, vol. 59, no. 7, 12 Août 1991, pages 857-859, XP000233772 J.Y.ANDERSSON ET AL.: "Near-unity quantum efficiency of AlGaAs/GaAs quantum well infrared detectors using a waveguide with a doubly periodic grating coupler"
- PROCEEDINGS OF THE EUROPEAN SOLID STATE DEVICE RESEARCH CONFERENCE (ESSDERC), LEUVEN, SEPT. 14 -17, 1992, no. CONF. 22, 14 Septembre 1992, MAES H E;MERTENS R P; VAN OVERSTRAETEN R J, pages 223-226, XP000357104 WIPIEJEWSKI T ET AL: "Resonant wavelength selective photodetectors"
- APPLIED PHYSICS LETTERS, vol. 53, no. 18, 31 Octobre 1988, pages 1714-1716, XP000025729 HELM M ET AL: "Observation of grating-induced intersubband emission from GaAs/AlGaAs superlattices"
- IEEE JOURNAL OF QUANTUM ELECTRONICS, vol. 29, no. 4, 1 Avril 1993, pages 1112-1115, XP000368637 KASTALSKY A: "Infrared intraband laser induced in a multiple-quantum-well interband laser"
- ANDERSSON J.Y. ET AL: "Quantum efficiency enhancement of AlGaAs/GaAs quantum well infrared detectors using a waveguide with a grating coupler", 20. Mai 1991, APPLIED PHYSICS LETTERS, VOL.58, NO.20, PAGES 2264-2266, NEW YORK
- ANDERSSON J.Y. ET AL: "Coupling of Radiation into Quantum Well Infrared Detectors by the use of Reflection Gratings and Waveguide Structures", 1992, PLENUM PRESS, INTERSUBBAND TRANSITIONS IN QUANTUM WELLS, PAGES 1-13, NEW YORK

## Description

L'invention concerne un dispositif électronique à puits quantiques et notamment un dispositif laser ou détecteur d'ondes électromagnétiques.

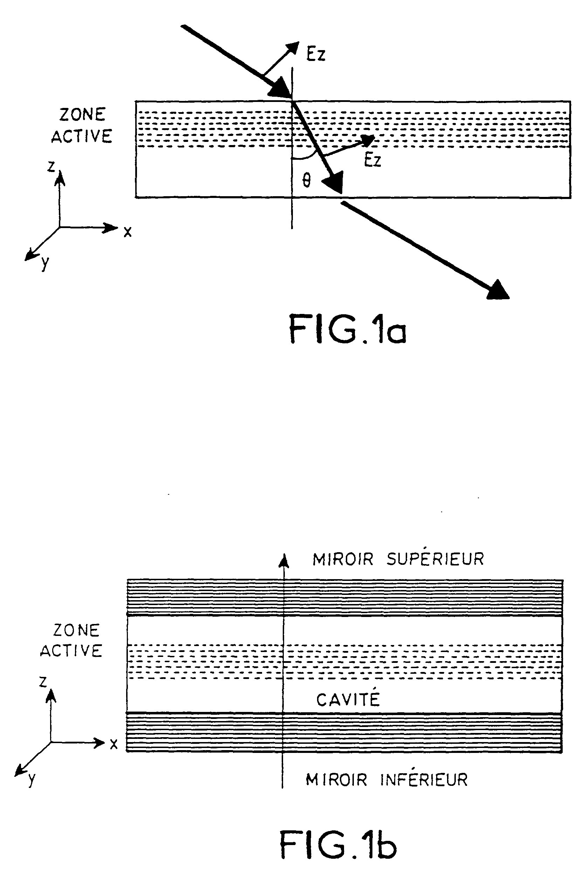

Les transitions intersousbandes sont utilisées pour la détection infrarouge, pour la modulation et pour l'émission. Dans la plupart des systèmes épitactiques, et notamment dans le système GaAs/AlGaAs, les règles de sélection sur la polarisation de la lumière interdisent l'interaction (absorption ou émission) de la lumière avec les puits à incidence normale. Les transitions intersousbandes ne sont sensibles qu'au champ selon z si z est la direction de croissance perpendiculaire au plan des couches. Plus précisément, l'interaction est proportionnelle à sin²θ où θ est l'angle de propagation de la lumière mesuré par rapport à la direction z (figure 1a).

Par ailleurs, on connaît les lasers à émission par la surface VCSEL's (Vertical Cavity Surfaces Emitting Lasers) qui fournissent d'excellentes performances. La cavité est alors une microcavité plane réalisée par des dépôts de couches minces de part et d'autre de la zone active et perpendiculaires à l'axe z de croissance (figure 1b). Les lasers émettent alors selon la direction z. Dans ce cas, la microcavité a pour effet de renforcer le champ dans le plan des couches (plan xy) qui peut se coupler avec la zone active du laser (pas de règles de sélection sur la polarisation du champ pour les transitions interbandes). La même idée ne peut pas s'appliquer directement aux transitions intersousbandes à cause de la règle de sélection sur la polarisation du champ comme cela est indiqué précédemment.

L'invention concerne une structure permettant dans un système à transitions intersousbande de fonctionner à incidence normale au plan des couches et utilisant l'effet de cavité optique.

L'invention concerne donc un dispositif optoélectronique à puits quantiques comportant un empilement de couches de largeurs de bandes interdites différentes et constituant des puits quantiques possédant dans la bande de conduction au moins deux niveaux d'énergie permis, cet empilement de couches étant compris entre deux moyens de réflexion, caractérisé en ce qu'il comporte un réseau de diffraction compris entre l'un des miroirs et l'empilement de couches.

Les différents objets et caractéristiques de l'invention apparaîtront plus clairement dans la description qui va suivre et dans les figures annexées qui représentent :
- les figures 1a et 1b, des dispositifs connus dans la technique ;
- les figures 2a et 2b, des exemples de réalisation d'un dispositif selon l'invention ;
- les figures 3a à 3c, des exemples de dispositifs fonctionnant en réflexion ;
- les figures 4a et 4b, des courbes caractéristiques de fonctionnement en détecteur des dispositifs des figures 3a à 3c;
- la figure 5, une courbe caractéristique de fonctionnement en détecteur du dispositif de la figure 2a.
- les figures 6a et 6b, des caractéristiques de fonctionnement d'un modulateur selon l'invention fonctionnant en réflexion ;
- les figures 7a et 7b, des caractéristiques de fonctionnement d'un modulateur selon l'invention fonctionnant en transmission ;
- la figure 8, une courbe de réponse d'un modulateur ne comportant pas de cavité.

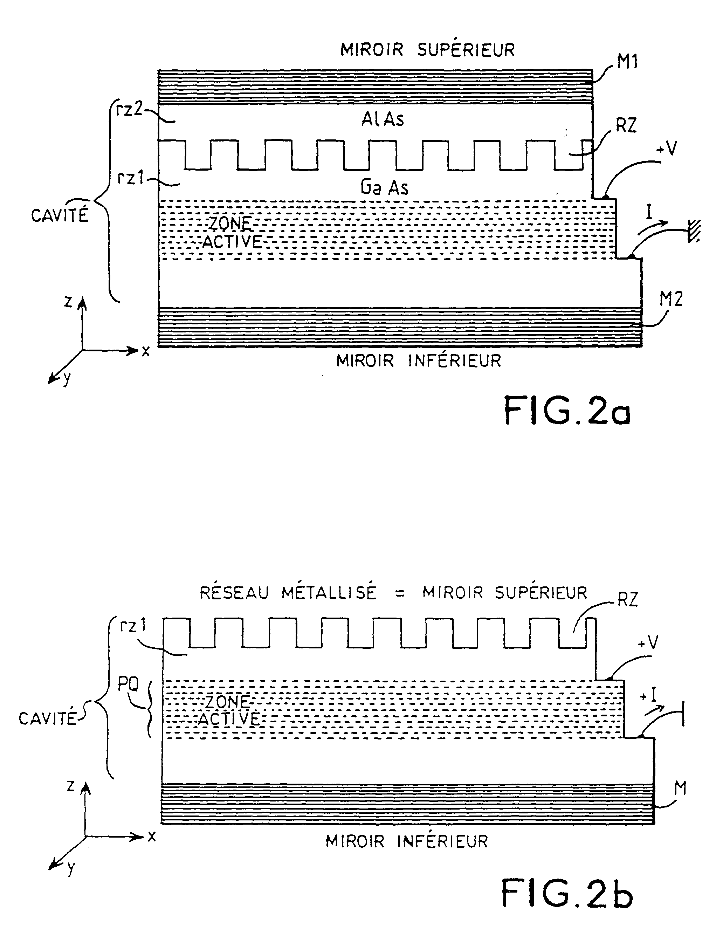

En se reportant à la figure 2a, on va donc décrire un exemple de réalisation selon l'invention. La structure de la figure 2a comporte un empilement de couches PQ de matériaux semiconducteurs de largeur de bandes interdites différentes et d'épaisseurs telles qu'elles constituent un empilement de puits quantiques. Cet empilement est compris entre deux miroirs M1 et M2 constituant une cavité optique. Ces miroirs M1 et M2 sont de préférence des miroirs de Bragg.

Entre le miroir M1 et l'empilement PQ est prévu un réseau de diffraction RZ. Ce réseau est constitué d'une couche rz1 accolée à l'empilement des couches PQ et possédant une surface présentant des inégalités de reliefs (des créneaux par exemple). Une deuxième couche rz2, en matériau d'indice de réfraction différent de celui de la couche rz1 (inférieur par exemple), recouvre les reliefs de la couche rz1. La couche rz2 porte le miroir M1.

Le dispositif comporte des électrodes connectée électriquement aux deux faces de l'empilement PQ. Ces électrodes permettent de polariser la structure et de l'alimenter en courant. Ces électrodes permettent également de connecter un détecteur de courant pour permettre un fonctionnement du dispositif en détecteur optique.

La figure 2b représente une variante de réalisation selon laquelle on ne prévoit pas le miroir supérieur M1 de la figure 2a. Par contre la surface supérieure en reliefs de la couche rz1 est rendue réfléchissante, par une métallisation par exemple, de façon à constituer à la fois le réseau de diffraction et le miroir supérieur de la cavité optique. L'invention s'applique aux transitions intersousbandes ou à tout autre système vérifiant les mêmes règles de sélection : la transition n'est sensible qu'au champ Ez perpendiculaire aux couches alors que la direction d'émission ou de réception est la direction z. La cavité peut être une microcavité semblable à celle réalisée dans les lasers VCSEL's ou non, la microcavité offrant en général des avantages en termes d'intégration et de performances. Les réseaux peuvent être à une dimension (une seule polarisation est couplée) ou à deux dimensions (les deux polarisations sont couplées) et peuvent être de forme variable (lamellaire, triangulaire, blazzée ...) sans que le principe de fonctionnement ne soit changé.

Nous allons illustrer ci-dessous les améliorations de performances apportées par l'introduction de microcavité pour des dispositifs utilisant des transitions intersousbandes dans des puits GaAs/AlGaAs et fonctionnant à incidence nulle. Ces exemples ne sont pas limitatifs et ne constituent pas des optimisations absolues mais donnent une image réaliste des performances accessibles dans ces structures. Pour les transitions intersousbandes, l'idée peut s'appliquer à la détection, la modulation ou l'émission.
A) Dans la détection et l'émission, il faut distinguer deux cas :
   A1) on s'intéresse à une gamme spectrale large (cas des imageurs thermiques usuels). Le spectre du rayonnement incident est large (par exemple 8-12 µm), la réponse spectrale du détecteur est large également (par exemple 8-10 µm) et le signal mesuré est proportionnel à la puissance absorbée totale intégrée sur tout le spectre. La microcavité a pour effet de réduire la largeur spectrale en même temps qu'elle augmente la réponse pic, en gardant l'intégrale à peu près constante.
   A2) on s'intéresse à la réponse sur un spectre étroit. En particulier, on cherche à obtenir une réponse élevée à une longueur d'onde précise, par exemple la raie 10.6 µm du laser CO₂. La structure a alors un double avantage : elle augmente la réponse à la longueur d'onde voulue, et en même temps, elle réduit la réponse aux longueurs d'onde voisines qui induisent du bruit sur la mesure.

Deux illustrations vont être données pour la détection. Les processus d'absorption et d'émission étant similaires, les conclusions pour l'émission (fonctionnement en laser) seront les mêmes que pour la détection à une longueur d'onde donnée. En particulier, cette idée s'applique parfaitement aux lasers intersousbandes.

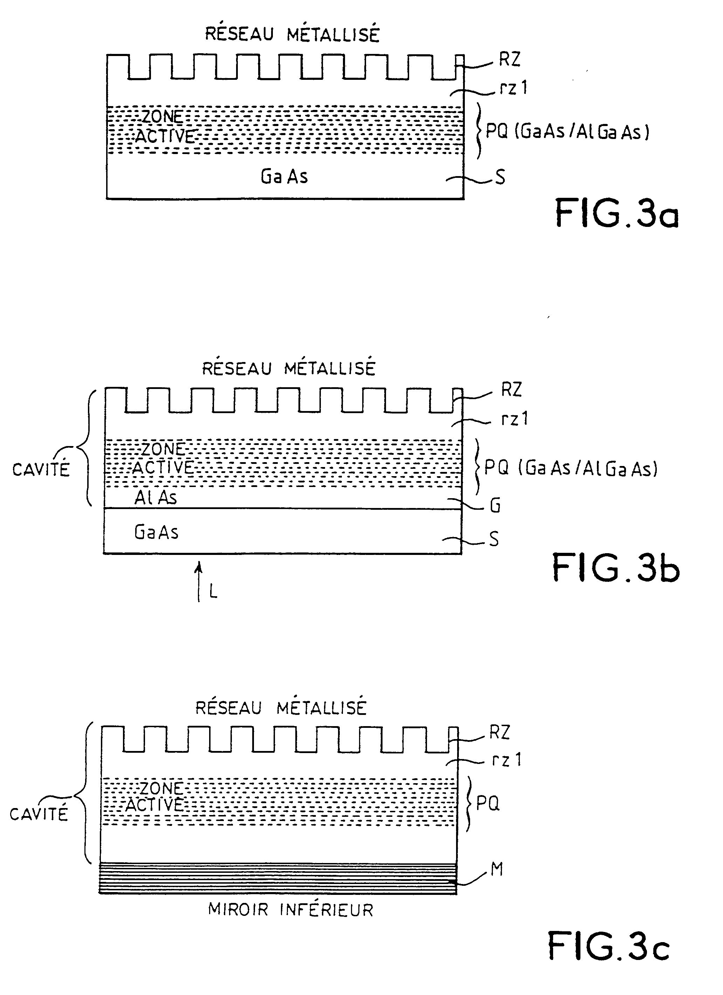

1) On s'intéresse aux détecteurs couplés par un réseau métallisé fonctionnant par réflexion (figure 2b). On utilise ici 40 puits dopés 5x10⁹ cm-² avec une courbe d'absorption des puits centrée à 10 µm et de largeur 10 meV. Cette zone active va être couplée avec un réseau lamellaire (1 dimension) dont on va optimiser la géométrie pour obtenir la réponse pic maximale. La métallisation sur le réseau constitue un miroir. Cette optimisation est faite dans 3 cas tels que représentés en figures 3a à 3c.

La figure 3a représente la structure de puits quantiques PQ à laquelle est associé un réseau de diffraction RZ, l'ensemble étant réalisé sur un substrat.

La figure 3b représente un dispositif dans lequel l'empilement de puits quantiques PQ est réalisé sur une couche de guidage G épaisse (3,5 µm) d'indice optique inférieur à celui des matériaux de l'empilement PQ. Par exemple, la couche G est en AlAs l'empilement PQ est en GaAs/AlGaAs et le substrat est en GaAs. Dans ces conditions, la lumière L arrivant dans le dispositif à travers le substrat traverse le substrat S, la couche G puis l'empilement PQ où elle est partiellement absorbée. La lumière non absorbée atteint le réseau RZ qui la diffracte vers l'empilement PQ qui en absorbe une partie. La lumière non absorbée est réfléchie vers le réseau par l'interface empilement PQ/couche G.

La figure 3c représente un dispositif avec miroir de Bragg M tel que le dispositif de la figure 2b.

Dans les 2 derniers cas, on a une cavité entre 2 miroirs, le métal d'une part et l'interface GaAs/AlAs d'autre part. L'épaisseur de la cavité est choisie pour que la cavité résonne à 10 µm.

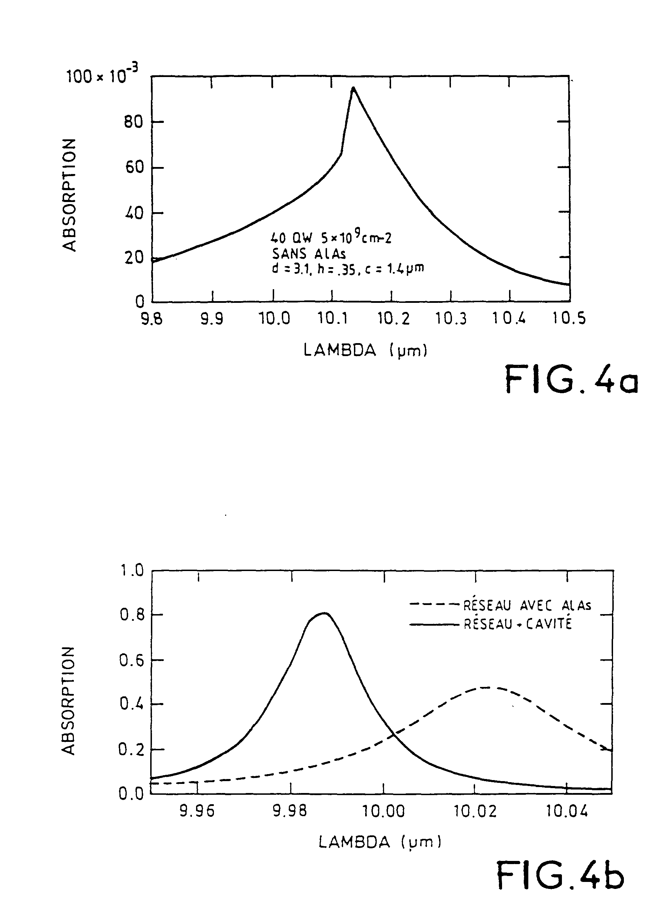

La figure 4a montre l'absorption sans AlAs. Le spectre est large et l'absorption pic est faible (9.5 %).

La figure 4b montre l'absorption dans les cas des dispositifs des figures 3b, 3c. Noter les changements d'échelle en abscisses et ordonnées entre les figures 4a et 4b. Les spectres sont étroits et l'absorption pic est forte (48 % avec AlAs épais et 81 % avec le miroir de Bragg). La cavité est plus performante avec le miroir de Bragg qui a un plus fort coefficient de réflexion que la simple couche d'AIAs, le spectre est plus étroit et l'absorption plus forte.

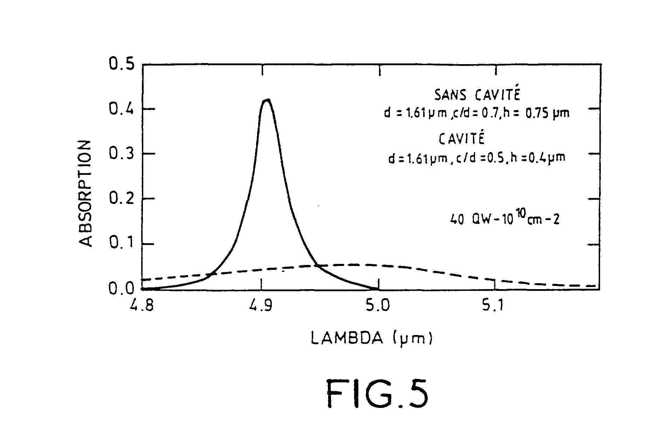

2) On va maintenant illustrer l'effet cavité sur des détecteurs couplés par réseaux diélectriques (GaAs gravé non métallisé) utilisés en transmission. On a une couche de 40 puits quantiques dopés à 10¹¹ cm-² et ayant une transition à 5 µm avec une largeur de 10 meV. Sur la figure 5, on compare l'absorption dans la couche dans deux cas :
i) le réseau est gravé dans GaAs et aucune autre structure n'est ajoutée. Il n'y a donc pas de miroir formant cavité. Le spectre d'absorption est large et l'absorption pic est faible (5,6 %).
ii) La structure précédente est recouverte de 3 couches CaF₂/ZnSe/CaF₂ constituant le miroir supérieur M2 et on dispose sous la zone active 5 périodes de AlAs/GaAs constituant le miroir inférieur M1. Cela correspond au dispositif de la figure 2a. On a donc une cavité. Le spectre d'absorption est étroit et l'absorption pic est importante (43 %) illustrant l'effet microcavité sur l'absorption du détecteur et mettant en évidence l'efficacité de l'invention.

Le dispositif de l'invention peut également fonctionner en modulateur.

Dans le cas d'un modulateur comportant un réseau métallisé comme en figure 2b, le modulateur fonctionne en réflexion.

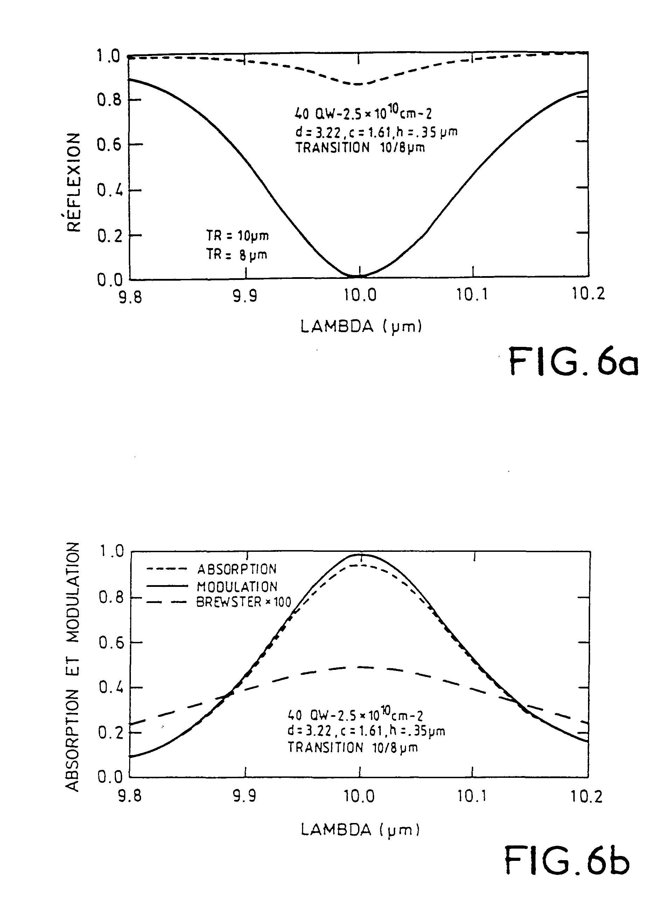

On atteint une absorption de 95.6 % (figure 6a) et une profondeur de modulation de 99.4 % (figure 6b). On note que les largeurs spectrales de modulation sont plus faible avec cavité que sans cavité.

Lorsque le modulateur est du type du dispositif de la figure 2a, il fonctionne en transmission.

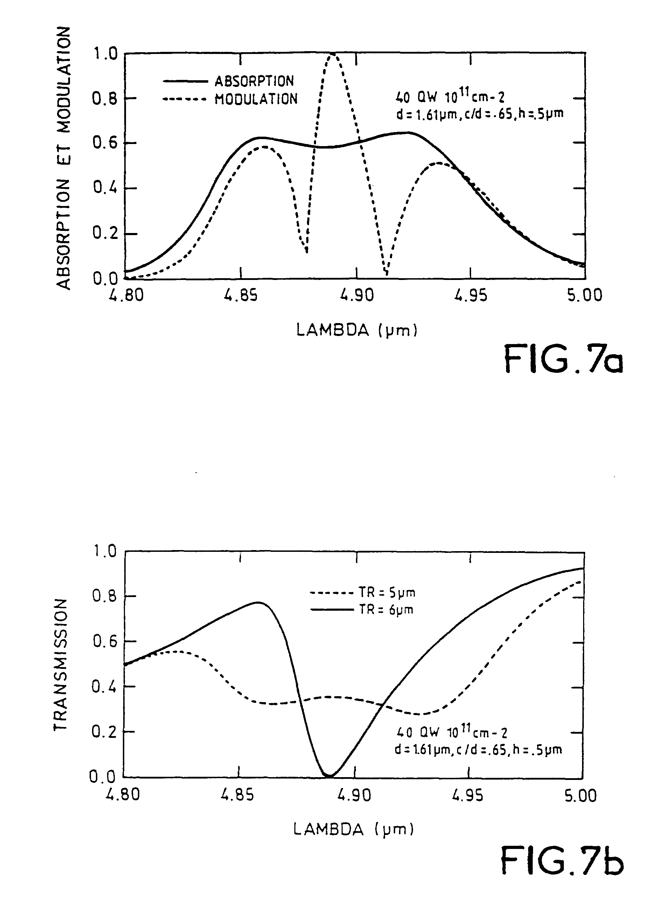

Les figures 7a et 7b montrent les performances d'un tel modulateur avec un dopage faible (10¹¹cm²) et une microcavité formée par un miroir de Bragg inférieur M1 (5 périodes de GaAs/AlAs) et un miroir de Bragg supérieur M2 déposé sur le réseau (CaF₂/ZnSe/CaF₂). Quand la longueur d'onde d'absorption des puits passe de 5 à 6 µm sous l'effet du champ électrique, le coefficient d'absorption de la zone active mais également l'indice sont modifiés de façon importante. Il s'ensuit que la modulation de la transmission de la microcavité dépend de la longueur d'onde, pouvant même changer de signe selon la longueur d'onde. Les modulations sont très importantes, en particulier dans la partie centrale du spectre (> 99 %). Les transmissions dans l'état passant sont modestes (30 %) si on utilise la forte modulation du pic central et sont fortes (80 %) si on utilise la modulation plus faible des pics latéraux. Il est important de noter qu'en variant les paramètres de réseau et de cavité, on peut modifier dans une large mesure les modulations et les transmissions dans l'état passant.

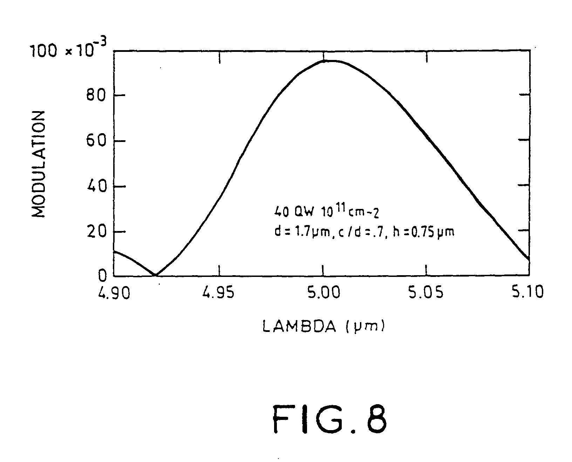

Il est à noter qu'un modulateur fonctionnant en transmission avec un réseau diélectrique et un dopage faible (10¹¹cm-²) mais non compris dans une cavité ne donne qu'une modulation limitée à 10 % et fournit une courbe de réponse telle que représentée en figure 8.

On voit donc que l'invention permet d'obtenir des résultats significatifs. Dans les exemples qui précèdent, on a pris ici des microcavités avec des miroirs de faible coefficient de réflexion. En particulier dans le cas des réseaux diélectriques, on aurait intérêt à prendre des miroirs plus réfléchissants (davantage de périodes, couches avec différences d'indice plus grande comme GaAs/Oxyde d'Aluminium ...). Le champ d'investigation des structures possibles est donc très large et les gains de performances peuvent être encore supérieurs à ceux décrits ici.

Un tel dispositif peut être réalisé sous forme matricielle. Différents dispositifs optoélectroniques élémentaires sont alors réalisés sur un même substrat.

## Revendications

1. Dispositif optoélectronique à puits quantiques comportant un empilement de couches (PQ) de largeurs de bandes interdites différentes et constituant des puits quantiques possédant dans la bande de conduction au moins deux niveaux d'énergie permis, cet empilement, de couches étant compris entre deux moyens de réflexion (M1, M2) constituant une cavité optique, **caractérisé en ce qu'**il comporte un réseau de diffraction (RZ) compris entre l'un des miroirs (M1) et l'empilement de couches (PQ).

2. Dispositif selon la revendication 1, **caractérisé en ce que** le réseau (RZ) est constitué de deux couches (rz1, rz2) délimitées par une surface présentant des reliefs, la couche (rz1) accolée à l'empilement de couches de puits quantiques (PQ) ayant un indice différent de celui de la couche accolée (rz2) accolée au miroir (M1).

3. Dispositif selon la revendication 2, **caractérisé en ce que** les reliefs du réseau sont de forme linéaire.

4. Dispositif selon la revendication 2, **caractérisé en ce que** le réseau est à deux dimensions.

## Claims

1. Optoelectronic quantum-well device comprising a multilayer stack (PQ) comprising layers of different band-gap widths and constituting quantum wells possessing, in the conduction band, at least two allowed energy levels, this multilayer stack lying between two reflection means (M1, M2) constituting an optical cavity, **characterized in that** it includes a diffraction grating (RZ) lying between one of the mirrors (M1) and the multilayer stack (PQ).

2. Device according to Claim 1, **characterized in that** the grating (RZ) consists of two layers (rz1, rz2) bounded by a surface having raised features, the layer (rz1) alongside the quantum-well multilayer stack (PQ) having a different index from that of the adjacent layer (rz2) alongside the mirror (M1).

3. Device according to Claim 2, **characterized in that** the raised features of the grating are of linear form.

4. Device according to Claim 2, **characterized in that** the grating is a two-dimensional grating.

## Patentansprüche

1. Optoelektronische Vorrichtung mit Quantentöpfen, die einen Stapel (PQ) aus Schichten umfaßt, die unterschiedliche Breiten der verbotenen Bänder besitzen und Quantentöpfe bilden, die im Leitungsband wenigstens zwei erlaubte Energieniveaus besitzen, wobei dieser Schichtstapel zwischen zwei Reflexionsmitteln (M1, M2), die eine optische Kavität bilden, enthalten ist, **dadurch gekennzeichnet, daß** sie ein Beugungsgitter (RZ) umfaßt, das zwischen einem der Spiegel (M1) und dem Schichtstapel (PQ) enthalten ist.

2. Vorrichtung nach Anspruch 1, **dadurch gekennzeichnet, daß** das Gitter (RZ) aus zwei Schichten (rz1, rz2) gebildet ist, die durch eine Reliefs aufweisende Oberfläche begrenzt sind, wobei die Schicht (rz1), die an den Quantentopf-Schichtstapel (PQ) geklebt ist, einen Index besitzt, der von jenem der Schicht (rz2), die an den Spiegel (M1) geklebt ist, verschieden ist.

3. Vorrichtung nach Anspruch 2, **dadurch gekennzeichnet, daß** die Reliefs des Gitters eine geradlinige Form haben.

4. Vorrichtung nach Anspruch 2, **dadurch gekennzeichnet, daß** das Gitter zweidimensional ist.
